# EUROPEAN PATENT SPECIFICATION

(11) **EP 4 194 757 B1**
(45) Date of publication and mention of the grant of the patent: **26.03.2025**
(21) Application number: 21383123.3
(22) Date of filing: 10.12.2021
(51) Int. Cl.: F24C 7/08, A47L 15/42, D06F 34/28, H05B 6/64, H05K 1/02

(54) **OPERATING DEVICE FOR AN ELECTRICAL DOMESTIC APPLIANCE AND ELECTRICAL DOMESTIC APPLIANCE**
BEDIENVORRICHTUNG FÜR EIN ELEKTRISCHES HAUSHALTSGERÄT UND ELEKTRISCHES HAUSHALTSGERÄT
DISPOSITIF DE COMMANDE POUR UN APPAREIL ÉLECTRIQUE DOMESTIQUE ET APPAREIL ÉLECTRIQUE DOMESTIQUE

(43) Date of publication of application: 14.06.2023
(73) Proprietor: E.G.O. Elektro-Gerätebau GmbH, 75038 Oberderdingen (DE)
(72) Inventor: Gutierrez, Manolo, 08360 Canet de Mar (ES); Gonzalez, Orlando, 08172 Sant Cugat del Valles (ES); Gamiz, Francesc, 08530 La Garriga (ES)
(74) Representative: Patentanwälte Ruff, Wilhelm, Beier, Dauster & Partner mbB

(56) References cited:
- FR-A1- 2 998 041
- US-A1- 2002 089 044
- US-A1- 2008 298 031

## Description

### Field of application and prior art

The invention is directed to an operating device for an electrical domestic appliance or a household appliance, respectively. Furthermore, the invention is directed to such an electrical domestic or household appliance with such an operating device.

It is known from EP 859 467 A1 to provide an operating device for a hob with two component carriers being arranged in parallel with some distance between them. A top component carrier is a sensor component carrier with a plurality of capacitive sensor elements affixed to it. They can be pressed against the underside of a hob plate, alternatively against the backside of an operating panel of any given electrical domestic appliance. The sensor component carrier is held by a holding device, which again is mounted to the other component carrier, wherein this other component carrier is a basic component carrier with electrical components on it. This basic component carrier again is mounted to an operating housing, in which operating housing the operating device is arranged.

It is known from US 2002/0089044 A1 to provide an MEMS package in the form of a flex circuit interconnect sub-assembly. A flex circuit is held on a carrier in the manner as in a frame, where the frame surrounds the flex circuit and does also fully cover the outer edge region on both sides for securely holding the flex circuit.

Another form of providing a printed circuit board with passive devices to be provided as single parts is known from US 2008/0298031 A1. The circuit board may be provided with thin film filter devices, wherein a silicon substrate may be used as a basis.

An operating device for a hob is known from FR 2 998 041 A1. The operating device has capacitive sensor elements and a display. The capacitive sensor elements shall be pressed against an underside of a hob plate for being operated from above by applying a finger to the hob plate.

### Problem and solution

It is an object of the invention at hand to provide an operating device for an electrical domestic appliance as well as such an electrical domestic appliance, with which problems in the prior art can be solved or avoided, and with which it is possible to hold a sensor component carrier in simple and practical manner as well as to provide a simple construction and practical manufacture.

This object is achieved by an operating device with the features of claim 1 as well as an electrical domestic or household appliance having such an operating device with the features of claim 15. Advantageous and preferred embodiments of the invention are the subject-matter of the sub-claims and are explained in detail hereinafter.

The operating device which can be used or inserted into an electrical domestic or household appliance has a flat and planar sensor component carrier, wherein this sensor component carrier has a front side and a rear side. At least one capacitive sensor element is arranged on the front side, preferably between five and twenty capacitive sensor elements. They may be applied to the front side as a coating with a thickness of 0.01 mm to 1 mm, for example as metallic fields made of copper as is conventional for printed circuit boards. The operating device has a further basic component carrier with electrical circuit components thereon, for example discrete components, resistors, capacitors, relays and/or microcontrollers. A holding device is provided which may be mounted to the basic component carrier, preferably in fixed manner. The holding device is provided for the sensor component carrier and serves to hold this sensor component carrier in a predefined position, in particular behind an operating panel of an electrical domestic appliance.

According to the invention, the sensor component carrier has a planar extension or is a flat plate or board, respectively, with an extension direction and end edges. This extension direction runs from one said end edge to the other end edge, with the consequence that the end edges extend transversely to the extension direction. Preferably, the end edges are parallel to each other, such that even more preferably the sensor component carrier is basically in a rectangular shape with a specific length and a specific width. Furthermore, the sensor component carrier is narrower along the direction of extension at its front side than at its rear side in such a way that the rear side projects beyond the front side at or along both end edges in a projection or view from above onto the sensor component carrier. This means that the rear side is longer or wider than the front side. In one simple embodiment, parallel and opposite end edges are at an oblique angle to the plane of the rear side, such that the cross-section of the sensor component carrier is a trapezoid.

This specific shape of the sensor component carrier allows for various options, one of them making it easier to hold the sensor component carrier at its end edges or the outermost edges of the end edges with a holding device such that the holding device does not protrude over the front side of the sensor component carrier. Another advantage of the invention is the option to hold the end edges of the sensor component carrier in safe and defined manner.

In one embodiment of the invention, the sensor component carrier is elongated with a length that is at least 50% greater than its width, preferably being at least double or triple its width. The direction of extension is perpendicular to the longitudinal direction of the sensor component carrier or its length, respectively. Furthermore, this afore-said direction of extension is the width direction and defines the width of the sensor component carrier. In this way, the width at the rear side of the sensor component carrier is greater or longer, respectively, than the width at the front side of the sensor component carrier. This can also serve to achieve the trapezoid cross-section mentioned before, which may for example have the edges with an oblique angle.

In a further embodiment of the invention, the rear side along the direction of extension is wider than the front side by a total of 1 mm to 4 mm or 50% to 500% of the thickness of the sensor component carrier, respectively. This means that in preferable thicknesses of the sensor component carrier being between 1 mm up to 3 mm, the sensor component carrier is rather thin with a length and a width being significantly more. The difference between the width at the front side and the width at the rear side can be about the thickness of the sensor component carrier. In one specific embodiment, this could lead to the end edges being at an oblique angle of about 45° to the rear side.

According to a further aspect of the invention, the end edges of the sensor component carrier can either be continuous or straight or along a straight line, respectively. Alternatively, the end edges can be interrupted such as toothed or alike, which may in some embodiments allow for an easier mounting of the sensor component carrier in a holding device for it. Even in such an embodiment with interrupted end edges, their basic extension should be along a straight line to facilitate manufacturing and assembly.

In a preferred embodiment of the invention, the two juxtaposed end edges are designed in the same manner, in particular continuous and uniform along their length. In particular, they may have a constant profile in each case. A preferable option is to design the two end edges as mirrored to one another. This allows for example for the two end edges being juxtaposed to be straight and/or parallel to one another.

In one optional embodiment of the invention, an end edge has an end edge face running between the rear side and the front side or from the rear side to the front side, respectively. This end edge face is formed continuously along the end edge such that the sensor component carrier has a constant cross-section. In this way it is possible for the end edge face to form a constant end edge angle to the rear side. Such an angle may be between 15° and 60°, preferably between 40° and 50°.

In an alternative embodiment of the invention, such an end edge face running from the rear side to the front side is formed in a non-continuous manner. For example, the end edge face may be formed in stepped manner with at least one step, possibly with two steps, between the rear side and the front side. It is possible for one step adjoining the rear side to be less high than half a thickness of the sensor component carrier. This may provide for the lowest step of the end edge contour to be lower than half the thickness of the sensor component carrier, which again allows for an easy and reliable mounting of the sensor component carrier to a holding device for its use in the appliance.

In the invention, the holding device extends essentially on or below the rear side of the sensor component carrier, although it holds the carrier along the two end edges. For this, the holding device has holding projections such that it partially overlaps the end edges or the end edge faces, respectively, of the sensor component carrier on opposite sides of said carrier by using at least one of the holding projections. In this way, the holding device with the holding projections holds the sensor component carrier positively in the direction perpendicular to its surface. Furthermore, the sensor component carrier can be held in a steady and parallel manner to the basic component carrier. In the invention, the holding device does not completely overlap the end edges or the end edge faces as far as the front side. Even more preferably, the holding device and the holding projections are somewhat below the front side or the plane of the front side, for example by at least 10% up to 50% of the thickness of the sensor component carrier.

This means that in the invention, the front side of the sensor component carrier is higher in a direction from the basic component carrier to the sensor component carrier than any part of the holding device including the holding projections. Furthermore, the holding device does not completely overlap the end edges or the end edge faces up to the front side, which can particularly easily be achieved by the specific form of the end edges. This means that the outermost and lowest part of the end edges are held by the holding projections and are therefore overlapped by the holding projections, but not the complete end edges or end edge faces, respectively. This means that with regard to an operating panel of an electrical domestic appliance behind which the operating device is arranged, is touched or contacted only by the sensor component carrier or the capacitive sensor elements arranged on its front side. All the other parts of the operating device do have some distance to the back side of this operating panel, even the holding device, even if this distance may be as small as less than 1 mm, for example 0.1 mm to 0.5 mm. In a further preferred embodiment, the holding projections may form the highest parts or highest areas of the holding device such that no other part or area of the holding device is higher than these holding projections. The holding projections are needed to reach over the outest part of the end edges to hold the sensor component carrier.

In a further embodiment of the invention, the holding projections are formed exactly complementary to the end edges or end edge faces of the sensor component carrier in a region of the projections, which point towards the end edges or end edge faces, respectively. The holding projections may even rest on these end edges or end edge faces for a good and reliable holding function. This may also serve for the purpose of the holding projections not running any risk of being damaged or damaging the end edges.

In an embodiment of the invention, the sensor component carrier is seated firmly in the holding device without screws or the like. In particular, the sensor component carrier is secured against movement, in particular in a direction along the end edges, by means of a latching connection or by means of a clamp, alternatively by abutting against a stop. These should most preferably be arranged near or at one end of the sensor component carrier. Such latching connections or clamps may work together with an abutment for the sensor component carrier at opposite ends of the carrier.

In a preferred manner, the front side of the sensor component carrier with the capacitive sensor elements being formed on it are or form the highest region or part of the operating device in a direction perpendicular to its surface. This is also the direction towards the operating panel of the domestic appliance mentioned before. These capacitive sensor elements should also protrude at least 10% of the thickness of the sensor component carrier above the holding device or the holding projections, respectively.

In a further preferred embodiment, the capacitive sensor elements may be formed by a metallic or electrically conductive coating on the sensor component carrier. This may be a metallic coating with copper, potentially covered with a very thin layer of tin as is known from conventional PCB. Alternatively, the capacitive sensor elements may be formed with graphite or carbon for example.

In an even further preferred embodiment, the sensor component carrier is a conventional printed circuit board with coatings in the form of tracks or surfaces or areas, respectively, on the front side and/or on the rear side. The capacitive sensor elements may preferably be in the form of surfaces, whereas these surfaces may be completely covered by electrically conductive material or in the form of a net or mesh, respectively. Such printed circuit boards are in particular according to FR4 or FR5 standard. They may also have vias or through-platings for an electrical contact from the front side to the rear side, preferably from the capacitive sensor elements on the front side to conductor tracks and/or contact fields on the rear side. This allows for an easy electrical contact to each of the capacitive sensor elements without the need of metallic contact springs, wires or the like. The vias or through-platings through the sensor component carrier should be very close or even within the capacitive sensor elements such that they produce no additional potential area for disturbing the electrical contacting of the sensor elements. The basic component carrier underneath the sensor component carrier can be provided with elastic or shape-changing and electrically conductive bodies, alternatively with springs or deformable, electrically conductive bodies or springs. They may be pressed from beneath against these contact fields on the rear side of the sensor component carrier. They are also connected to any circuits or microcontrollers on the basic component carrier as mentioned before. In a preferred embodiment of the invention, the sensor component carrier does not have any separate or discrete electrical components, not even SMD components. It should preferably be provided only with the capacitive sensor elements on the front side and contact fields or conductor tracks on the rear side.

In a further embodiment of the invention, the operating device has a display device, which preferably is an LC display or an LED display. The display device may be arranged next to the sensor component carrier with a lateral distance of 2 mm or 3 mm up to at least 10 mm. The display device has a front side which preferably runs in a parallel plane to the sensor component carrier. It is even more preferred for the display device to not project beyond or above the plane of the front side of the sensor component carrier for the same reasons as described above. The display device may also be held by the holding device or be affixed to it, respectively. This is but by other means than for the sensor component carrier.

In a preferred embodiment, the sensor component carrier has a long and rectangular form with a length along its end edges being two times up to five times its width. The number of capacitive sensor elements provided on the front side may vary between one and ten or even twenty.

The electrical domestic or household appliance according to the invention has an operating device as described before. The appliance has an operating panel behind which the operating device is arranged, for example an at least partly transparent glass panel or plastic panel. The operating device is affixed to the rear side of the operating panel or pressed against it with at least the front side of the sensor component carrier or only with its capacitive sensor elements, respectively. The display device mentioned before may also be provided on the operating device and behind the operating panel, which for this purpose should be transparent or at least partly light transmissive. The front side of the sensor component carrier should be parallel to the operating panel. On the front side of the operating panel, prints in the form of symbols, figures or letters may be provided to indicate for an operator where a specific function may be executed by touch switches comprising the capacitive sensor elements.

The basic component carrier may be affixed to a housing or the like, preferably in rigid manner. This housing may then preferably be affixed in the appliance or to the rear side of its operating panel, respectively.

### Short description of the drawings

In the following, embodiments of the invention will be described in detail with reference to the drawings. Throughout the drawings, the same elements will be denoted by the same reference numerals.
- Fig. 1: an oblique view onto an operating device according to the invention with a display and a sensor array with capacitive sensor elements on a sensor PCB,
- Fig. 2: a side view onto a baking oven as a domestic appliance with an operating panel, behind which the operating device of Fig. 1 is arranged,
- Fig. 3: the operating device of Fig. 1 without a housing showing a holding device with an LC-display and a sensor PCB with the capacitive sensor elements, the holding device being arranged on a basic PCB,
- Fig. 4: the holding device of Fig. 3 with only the sensor PCB with the capacitive sensor elements,
- Fig. 5: the sensor PCB with the capacitive sensor elements of Fig. 4,
- Fig. 6: a sectional view of a sensor PCB in the holding device similar to Fig. 4,
- Fig. 7: a variation of the cross-section of the sensor PCB in an adapted holding device,
- Fig. 8: the view onto the holding device of Fig. 4 without the sensor PCB,
- Fig. 9: an enlarged view onto Fig. 4 with the left end of the sensor PCB,
- Fig. 10: the view of Fig. 9 without the sensor PCB and
- Fig. 11: a side view onto Fig. 9.

### Detailed description of the embodiments

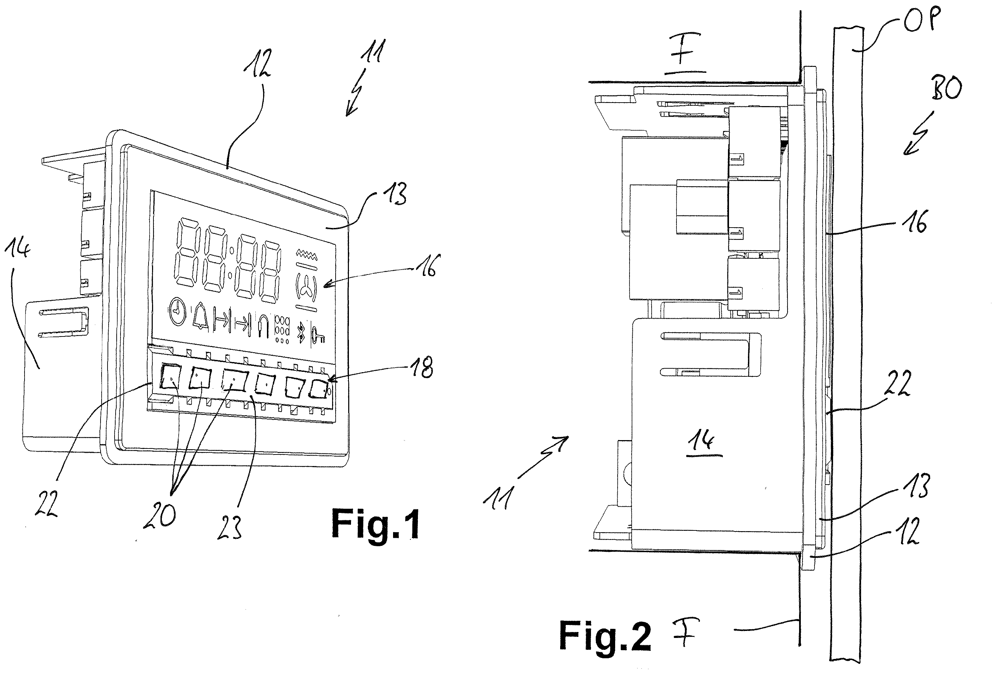

In Fig. 1, an oblique view of an operating device 11 according to the invention is shown. The operating device 11 has a housing 12, preferably made of plastic, with a front frame 13 and side flanges 14. The operating device 11 may be mounted to the rear side of an operating panel of a domestic appliance, which is shown in Fig. 2 later on. It may be affixed to any carrier structure or the like in the appliance, for example with a latching, which can be seen being arranged in the side flange 14.

On the front face of the operating device 11 and within the front frame 13, an LC-display 16 is provided together with a sensor array 18 made up of six capacitive sensor elements 20. The capacitive sensor elements 20 are rectangular and of identical shape and regular arrangement. The capacitive sensor elements 20 are provided on a front side 23 of a sensor PCB 22. Sensor PCB 22 preferably is an ordinary PCB, and a preferred manner for providing the capacitive sensor elements 20 includes coating with electrical conductive material. This may either be a copper plating, preferably with a thin coating of tin. Such is known in the fabrication of PCB's. Alternatively, the electrical conductive coating could be made up of material containing carbon or graphite, respectively. Another fabrication method is screen printing or spraying or the like. The capacitive sensor elements 20 are electrically connected to the inside of the operating device 11, which will be explained later on. The basic function of the operating device 11 with displaying function via the LC-display 16 and operating elements as touch switches including capacitive sensor elements 20 is known in the art.

Fig. 2 shows a cross-section of a small part of a baking oven BO having an operating panel OP, the operating device 11 being pressed against the backside of the operating panel OP. The housing 12 is fixed in a fixture F. Operating panel OP is transparent at least in the region of the LC-display 16 to be visible from the outside. Above the capacitive sensor elements 20 it is preferably not transparent, but symbols or icons may be printed to its front side indicating the place for a user to put a finger on for effecting touch operation as indicated. This is also well-known in the art.

As will be shown further in detail later on, it can be seen in Fig. 2 that a front side 23 of the sensor PCB 22 is the highest part of the operating device 11 such that at least or, preferably, only the front side 23 of the sensor PCB 22 abuts against the backside of the operating panel OP. To be exact, not the front side 23 itself is abutted against the backside of the operating panel OP, but the six capacitive sensor elements 20 are in direct contact with the backside of the operating panel. Preferably only the capacitive sensor elements 20 are in direct contact with the backside of the operating panel. This is detailed later on.

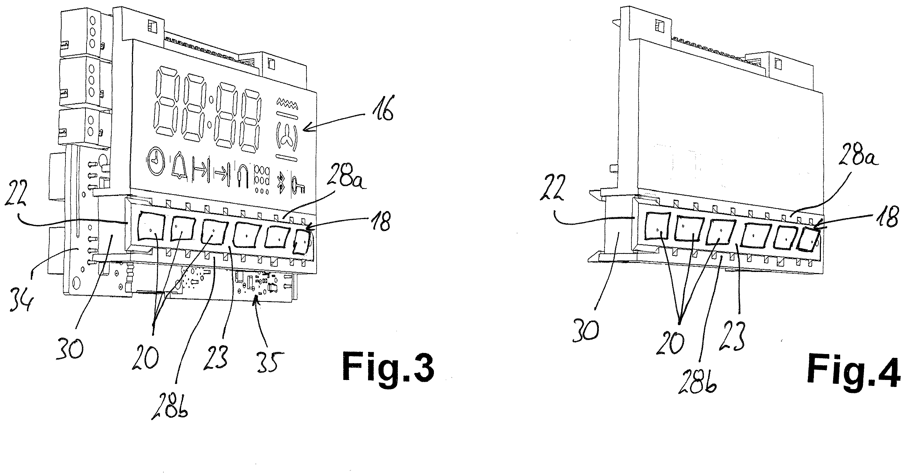

As can be taken from the oblique view of Fig. 3 corresponding to Fig. 1 without the housing 12, a holding device 30 for the sensor PCB 22 is provided, preferably made of plastic. The holding device 30 also carries the LC-display 16, which is affixed to it somehow. The holding device 30 again is mounted onto a basic PCB 34 of the operating device 11. This basic PCB 34 carries various electrical components 35 on its upper side, which are visible here. Further electrical components, in particular of larger size, may be provided on its underside. The LC-display 16 is also electrically connected to the basic PCB 34, as are the capacitive sensor elements 20 of the sensor PCB 22. This will be explained in detail later on.

Fig. 4 shows the holding device 30 without the LC-display 16 and without the basic PCB 34. Holding device 30 has a number of holding projections 28a and 28b, which are forming a kind of channel between them. The sensor PCB 22 is inserted into this channel and firmly held by the holding projections 28a and 28b.

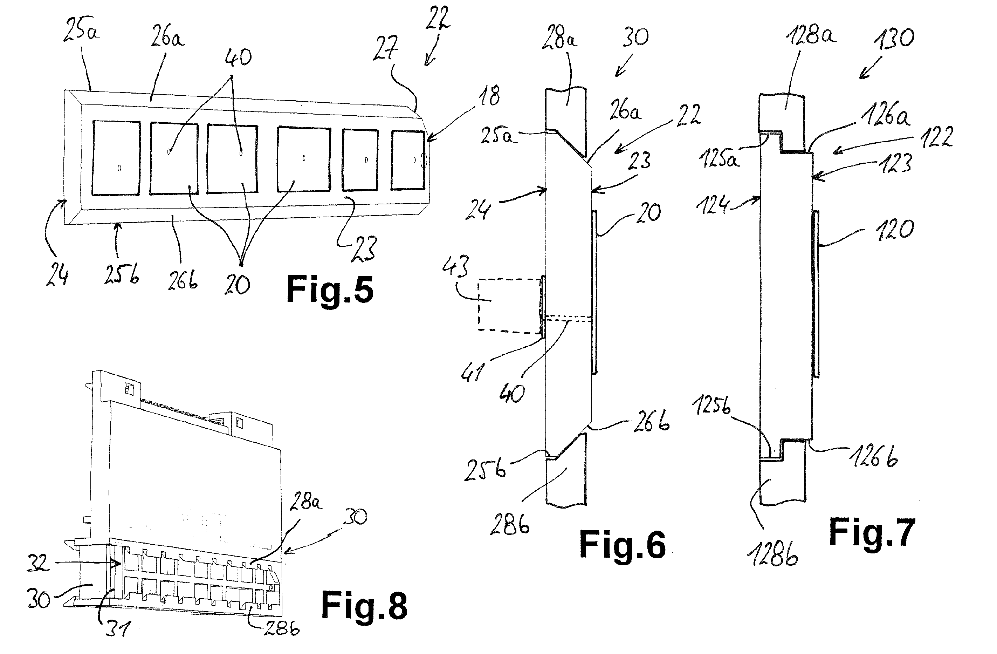

Fig. 5 shows an enlarged view onto the sensor PCB 22 of Fig. 4. Sensor PCB 22 has a specific cross-section with edge faces 26a and 26b along edges 25a and 25b. This specific cross-section can also be taken from the enlarged view of Fig. 6. The edge faces 26a and 26b are at an angle of about 45° to the rear side 24 as well as to the front side 23, which sides 23 and 24 are parallel to each other. This means that the above-mentioned direction of extension is from one edge 25a to the other edge 25b, which is transverse to its length. In case the sensor PCB 22 has a thickness of about 1 mm to 3 mm, the width at the front side 23 is slightly less than the width at the rear side 24 minus about 1.5 times the thickness. This is due to the edges 25a and 25b being ground somewhat at the transition to the rear side 24. This has the reason that due to the usual material of a PCB, which is glass fiber reinforced resin, and which might brake if it is too thin, too sharp edges might break in random manner. Such should be avoided, if possible. So, in the case shown here, the difference between the width at the front side 23 and the width at the rear side 24 is about 150% of the thickness of the sensor PCB 22 or, in other words, 20% of the maximum width of the sensor PCB 22 at the rear side 24.

The specific design of the edges 25a and 25b and the oblique edge faces 26a and 26b, respectively, allows for holding projections 28a and 28b of the holding device 30 to securely overlap a part of these edge faces 26a and 26b. But at the same time they are staying well back behind the plane of the front side 23. This serves to achieve a positive mechanical engagement or positive locking, respectively, of the sensor PCB 22 at the holding device 30 without holding projections 28a and 28b overlapping onto the front side 23. This would be necessary if the width of the front side 23 and of the rear side 24 would be identical with a conventional pure rectangular cross-section of the sensor PCB 22. It can be taken from Fig. 6 that it is sufficient for the holding projections 28a and 28b to be only 0.1 mm or 0.2 mm below the front side 23.

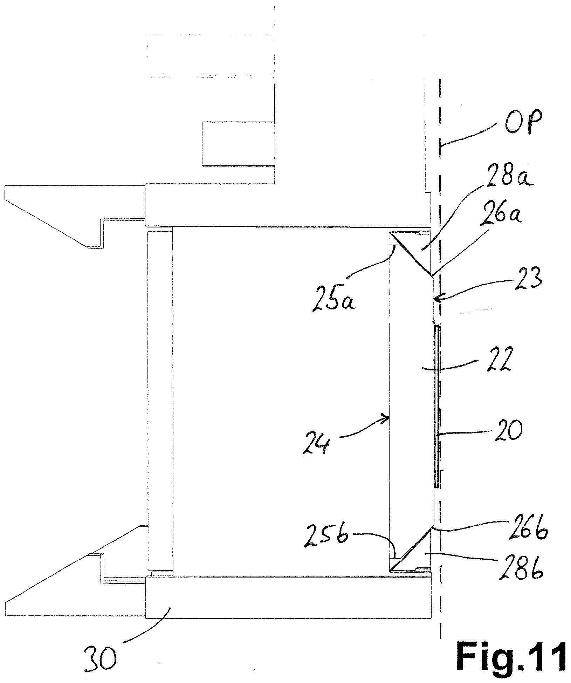

Not only is the front side 23 of sensor PCB 22 the highest portion or part of the operating device 11, but the capacitive sensor element 20 is even slightly higher due to its own thickness. The capacitive sensor element 20 may be made up of copper with a thin tin coating, the copper having a thickness of about 0.01 mm to 0.2 mm. As can be taken later on from the enlarged view of Fig. 11, this is sufficient to make sure that at least or only the capacitive sensor elements 20 abut against the backside of the operating panel OP, which in Fig. 11 is shown in dashed line.

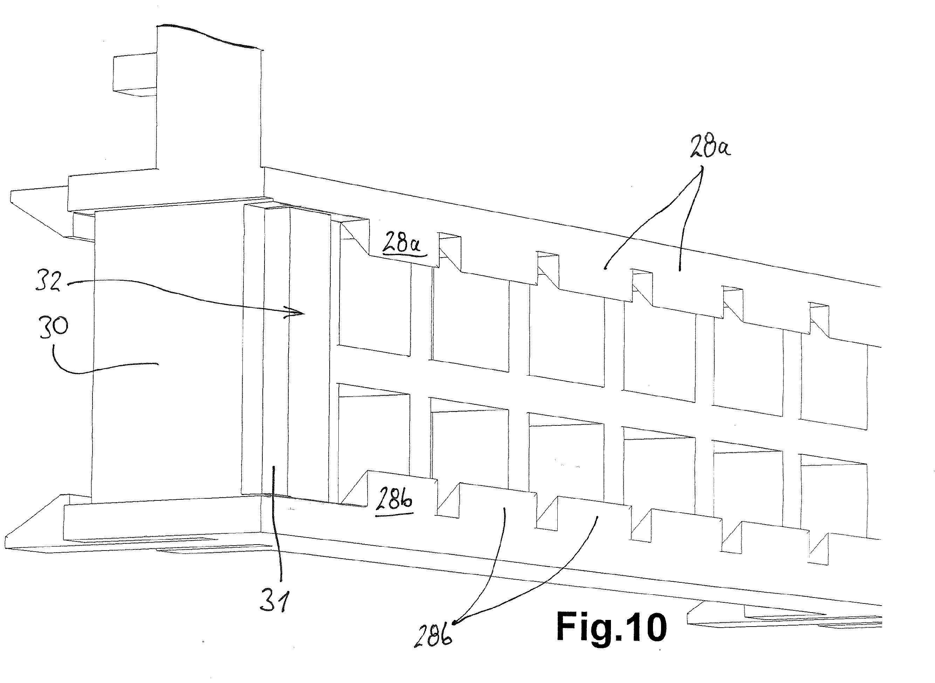

Fig. 6 also shows an electrical contact to the capacitive sensor element 20. For this, a hole is provided in the sensor PCB 22 with a through-plating 40 from the front side 23 to the rear side 24. This through-plating 40 is connected on the front side 23 to the capacitive sensor element 20. On the rear side 24, it is connected to a contact field 41, which preferably is made up in a similar manner as the capacitive sensor element 20. It can be connected via an electrically conductive contact body 43, which again can be connected to another similar contact field provided on the basic PCB 34. The electrically conductive contact body 43 can be made of electrically conductive foam as is known from EP 859 467 A1 cited in the beginning. As can be taken from Figs. 8 and 10, a channel 31 provided in the holding device 30 underneath the leftmost sensor element 20 can receive such a contact body 43 and hold it in place, or the contact bodies coud be placed in the latticed structure. As an alternative, a contact body being made up of a number of electrically conductive strips being separated by isolating strips coud be provided in channel 31 connecting to contact fields 41. As a further alternative, metal springs or the like could be provided.

Fig. 7 shows an alternative embodiment of a sensor PCB 122 with a capacitive sensor element 120 provided on its front side 123. Edges 125a and 125b are provided between the front side 123 and a rear side 124, wherein these edges or their edge faces 126a and 126b, respectively, may each be formed with a step or in stepped manner, respectively. This results in the edge faces 126a and 126b not being at a constant and oblique angle as shown in the example of Fig. 6, but being formed in a stepped manner. This may be somewhat more difficult to manufacture compared to the oblique edge faces of Fig. 6. At the same time, the result is the same and holding projections 128a and 128b, which are correspondingly formed, can firmly hold the sensor PCB 122 on the holding device 130. As can be taken from Fig. 7, this also results in a positive mechanical engagement. The manufacturing of such a PCB 122 may take more effort than the one of Fig. 6, but the sensor PCB 122 can be held even more exact than according to Fig. 6.

A combination of oblique and stepped edge faces can be provided. Also in the cases of Fig. 6 and Fig. 7, the edge faces 26a and 26b and 126a and 126b, respectively, are the same and one is mirrored after the other. It is also an option to vary the angles of the edge faces, or to provide one edge phase in oblique manner and the other in stepped manner.

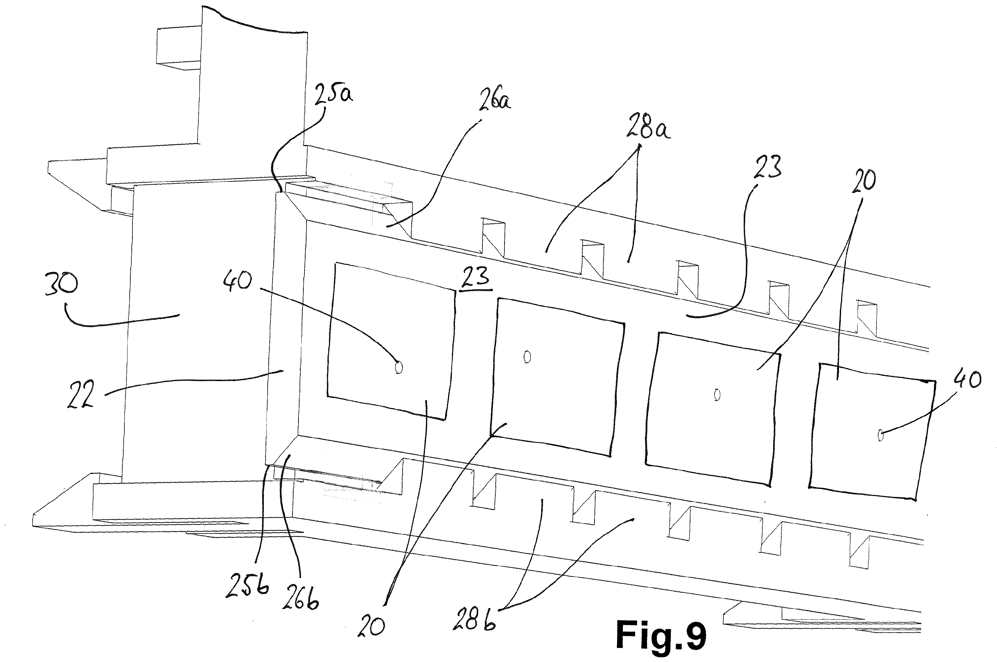

Fig. 8 shows the configuration of Fig. 4 without the sensor PCB. A reception channel 32 for inserting the sensor PCB 22 is formed by the holding projections 28a and 28b. Its underside is formed by a kind of grate forming the channels 31 for the above described contact bodies to reach through the holding device 30 down to the basic PCB 34. Fig. 10 clearly shows that the sensor PCB 22 can easily be inserted into the reception channel 32 and completely moved or pushed in, respectively, to reach the right end of the reception channel 32. This can be taken from Fig. 3, for example. If the holding projections 28a and 28b are pressed with slight force against the edge faces 26a and 26b, which does not pose a problem for inserting the sensor PCB 22, the holding force for this sensor PCB 22 at the holding device 30 is fully sufficient. A latching mechanism or the like could be provided for on the sensor PCB 22 and/or the holding device 30, respectively. Alternatively, the front frame 13 of the housing 12 which is moved over the basic PCB 34 and a part of the holding device 30 may abut at the left end of the sensor PCB 22 which is protruding slightly over the left side of the holding device 30, which for example can be taken from Fig. 9. In this manner, in the mounted state of the operating device 11 according to Fig. 1, the sensor PCB 22 is firmly secured in place and cannot be moved out of the channel 31.

As has been mentioned before, Fig. 11 is a side view onto the holding device 30 with the sensor PCB 22 being similar to the side view of Fig. 2. The front frame 13 of the housing 12 may be at the same height level as the holding devices 30a and 30b of the holding device 30. This means that it would stay clearly further away from the dashed rear side of operating panel OP. In this manner, clearly only the capacitive sensor elements 20 are in contact with this rear side of the operating panel OP, which serves for an excellent function of the capacitive touch switches formed thereby.

## Claims

1. Operating device (11) for an electrical domestic appliance (BO), the operating device (11) having:
- a flat and planar sensor component carrier (22, 122) with a front side (23, 123) and a rear side (24, 124), wherein at least one capacitive sensor element (20, 120) is arranged on the front side (23, 123),
- a further basic component carrier (34) with electrical circuit components (35) thereon,
- a holding device (30, 130) for the sensor component carrier (22, 122) being mounted to the basic component carrier (34),
wherein
- the sensor component carrier (22, 122) has a planar extension with one extension direction and end edges (25, 125), wherein the extension direction runs from one end edge (25, 125) to the other end edge (25, 125) such that the end edges (25, 125) extend transversely to the extension direction,
- the sensor component carrier (22, 122) is narrower along the direction of extension at the front side (23, 123) than at the rear side (24, 124) in such a way that the rear side (24, 124) projects beyond the front side (23, 123) at both end edges (25, 125) in the projection onto the sensor component carrier (22, 122),
- the holding device (30, 130) extends essentially on or below the rear side (24, 124) of the sensor component carrier (22, 122) and has holding projections (28, 128),
- the holding device (30, 130) partially overlaps the end edges (25, 125) or the end edge faces (26, 126) of the sensor component carrier (22, 122) on opposite sides of the sensor component carrier (22, 122) with in each case at least one of the holding projections (28, 128) and holds the sensor component carrier (22, 122) positively in the direction perpendicular to its surface,
**characterized in that**
- the holding device (30, 130) does not completely overlap the end edges (25, 125) or the end edge faces (26, 126) as far as the front side (23, 123),
- the front side (23, 123) of the sensor component carrier (22, 122) is higher in a direction from the basic component carrier (34) to the sensor component carrier (22, 122) than any part of the holding device (30, 130) including the holding projections (28, 128).

2. An operating device according to claim 1, **characterized in that** the sensor component carrier (22, 122) is elongated with a length that is at least 50% greater than the width, the direction of extension being perpendicular to the longitudinal direction of the sensor component carrier (22, 122) and defining the width of the sensor component carrier (22, 122), the width at the rear side (24, 124) being greater than the width at the front side (23, 123).

3. Operating device according to claim 1 or 2, **characterized in that** the rear side (24, 124) along the direction of extension is wider than the front side (23, 123) by a total of 1 mm to 4 mm or 50% to 500% of the thickness of the sensor component carrier (22, 122).

4. Operating device according to one of the preceding claims, **characterized in that** the two end edges (25, 125) are designed continuous and uniform along their length, in particular with a constant profile in each case, wherein preferably the design of the two end edges (25, 125) are mirrored to one another, in particular the two end edges (25, 125) which delimit the direction of extension being straight and/or parallel to one another.

5. Operating device according to one of the preceding claims, **characterized in that** an end edge face (26, 126) which runs between the rear side (24, 124) and the front side (23, 123) along the end edge (25, 125) is formed continuously, in particular runs straight, in such a way that the end edge face (26, 126) forms a constant end edge angle to the rear side (24, 124), preferably the end edge angle being between 15° and 60°.

6. Operating device according to any one of claims 1 to 4, **characterized in that** an end edge face (26, 126) extending between the rear side (24, 124) and the front side (23, 123) along the end edge (25, 125) is formed in a non-continuous manner in the direction from the rear side (24, 124) to the front side (23, 123), in particular is formed stepped with at least one step, wherein preferably a step adjoining the rear side (24, 124) is less high than half a thickness of the sensor component carrier (22, 122).

7. Operating device according to one of the preceding claims, **characterized in that** the front side (23, 123) of the sensor component carrier (22, 122) has at least 10% of its thickness over the holding projections (28, 128) or over the highest end edge faces (26, 126) of the sensor component carrier (22, 122), wherein preferably the holding device (30, 130) does not completely overlap the end edges (25, 125) or the end edge faces (26, 126) up to the front side (23, 123), wherein preferably the holding projections (28, 128) form the highest parts or areas of the holding device (30, 130) and/or no other area of the holding device (30, 130) is higher than the holding projections (28, 128).

8. Operating device according to one of the preceding claims, **characterized in that** the holding projections (28, 128) are formed exactly complementary to the end edges (25, 125) or end edge faces (26, 126) of the sensor component carrier (22, 122) in a region which points towards the end edges (25, 125) or end edge faces (26, 126) of the sensor component carrier (22, 122) and, if applicable, rests thereon.

9. Operating device according to one of the preceding claims, **characterized in that** the sensor component carrier (22, 122) is seated firmly in the holding device (30, 130) without screws or the like, and in particular is secured against movement by means of a latching connection or by means of a clamp.

10. Operating device according to one of the preceding claims, **characterized in that** the front side (23, 123) of the sensor component carrier (22, 122) with the capacitive sensor elements (20, 120) forms the highest region of the operating device (11) in a direction perpendicular to its surface, wherein in particular the sensor component carrier (22, 122) protrudes with at least 10% of its thickness above the other parts or regions of the operating device (11) such as the holding device (30, 130).

11. Operating device according to one of the preceding claims, **characterized in that** the capacitive sensor elements (20, 120) are formed by a metallic coating of the sensor component carrier (22, 122), in particular by a coating with copper.

12. Operating device according to one of the preceding claims, **characterized in that** the sensor component carrier (22, 122) is a conventional printed circuit board with coatings in the form of conductor tracks or conductive surfaces on the front side (23, 123) and/or on the rear side (24, 124).

13. Operating device according to one of the preceding claims, **characterized in that** the capacitive sensor elements (20, 120) on the front side (23, 123) of the sensor component carrier (22, 122) are conductively connected by means of through-platings (40) to conductor tracks and/or contact fields (41) on the rear side (24, 124) of the sensor component carrier (22, 122), wherein preferably an electrical contacting between conductor tracks and/or contact fields on the rear side (24, 124) of the sensor component carrier (22, 122) and the basic component carrier (34) are provided by means of elastic or shape-changing, electrically conductive bodies (43) or springs or deformable, electrically conductive bodies or springs, wherein in particular only the capacitive sensor elements (20, 120) and through-platings (40) and conductor tracks and contact fields (41) are provided on the sensor component carrier (22, 122), but no separate or discrete electrical components, wherein preferably only the capacitive sensor elements (20, 120) are provided on the front side (23, 123).

14. Operating device according to one of the preceding claims, **characterized in that** a display device, in particular an LC display (16) or an LED display, is arranged next to the sensor component carrier (22, 122), which preferably runs in a parallel plane, wherein preferably the display device (16) does not project beyond the plane of the front side (23, 123) of the sensor component carrier (22, 122).

15. Electrical domestic appliance (BO) with an operating device (11) according to one of the preceding claims, **characterised in that** the domestic appliance (BO) has an operating panel (OP) behind which the operating device (11) is arranged, wherein the operating device (11) is pressed at least with the front side (23, 123) of the sensor component carrier (22, 122) or with the capacitive sensor elements (20, 120) against the rear side of the operating panel (OP), wherein in particular the sensor component carrier (22, 122) extends parallel to the operating panel (OP) or the rear side of the operating panel (OP).

## Patentansprüche

1. Bedienvorrichtung (11) für ein elektrisches Haushaltsgerät (BO), wobei die Bedienvorrichtung (11) Folgendes aufweist:
- einen flachen und ebenen Sensorbauteilträger (22, 122) mit einer Vorderseite (23, 123) und einer Rückseite (24, 124), wobei auf der Vorderseite (23, 123) mindestens ein kapazitives Sensorelement (20, 120) angeordnet ist,
- einem weiteren Grundbauteilträger (34) mit darauf befindlichen elektrischen Schaltungsbauteilen (35),
- wobei eine Haltevorrichtung (30, 130) für den Sensorbauteilträger (22, 122) an dem Grundbauteilträger (34) angebracht ist,
wobei
- der Sensorbauteilträger (22, 122) eine flächige Ausdehnung mit einer Ausdehnungsrichtung und Endkanten (25, 125) aufweist, wobei die Ausdehnungsrichtung von einer Endkante (25, 125) zur anderen Endkante (25, 125) verläuft, so dass die Endkanten (25, 125) quer zur Ausdehnungsrichtung verlaufen,
- der Sensorbauteilträger (22, 122) entlang der Ausdehnungsrichtung an der Vorderseite (23, 123) schmaler ist als an der Rückseite (24, 124), so dass die Rückseite (24, 124) an beiden Endkanten (25, 125) in der Projektion auf den Sensorbauteilträger (22, 122) über die Vorderseite (23, 123) hinausragt,
- die Haltevorrichtung (30, 130) sich im Wesentlichen auf oder unter der Rückseite (24, 124) des Sensorbauteilträgers (22, 122) erstreckt und Haltevorsprünge (28, 128) aufweist,
- die Haltevorrichtung (30, 130) die Endkanten (25, 125) oder die Endkantenflächen (26, 126) des Sensorbauteilträgers (22, 122) auf gegenüberliegenden Seiten des Sensorbauteilträgers (22, 122) mit jeweils mindestens einem der Haltevorsprünge (28, 128) teilweise überlappt und den Sensorbauteilträger (22, 122) in Richtung senkrecht zu seiner Oberfläche formschlüssig hält,
**dadurch gekennzeichnet, dass**
- die Haltevorrichtung (30, 130) die Endkanten (25, 125) bzw. die Endkantenflächen (26, 126) nicht vollständig bis zur Vorderseite (23, 123) überdeckt,
- die Vorderseite (23, 123) des Sensorbauteilträgers (22, 122) in einer Richtung vom Grundbauteilträger (34) zum Sensorbauteilträger (22, 122) höher ist als irgendein Teil der Haltevorrichtung (30, 130) einschließlich der Haltevorsprünge (28, 128).

2. Bedienvorrichtung nach Anspruch 1, **dadurch gekennzeichnet, dass** der Sensorbauteilträger (22, 122) länglich ist und eine Länge aufweist, die mindestens 50 % größer ist als die Breite, wobei die Ausdehnungsrichtung senkrecht zur Längsrichtung des Sensorbauteilträgers (22, 122) ist und die Breite des Sensorbauteilträgers (22, 122) definiert, wobei die Breite an der Rückseite (24, 124) größer ist als die Breite an der Vorderseite (23, 123).

3. Bedienvorrichtung nach Anspruch 1 oder 2, **dadurch gekennzeichnet, dass** die Rückseite (24, 124) in Erstreckungsrichtung um insgesamt 1 mm bis 4 mm oder 50 % bis 500 % der Dicke des Sensorbauteilträgers (22, 122) breiter ist als die Vorderseite (23, 123).

4. Bedienvorrichtung nach einem der vorstehenden Ansprüche, **dadurch gekennzeichnet, dass** die beiden Endkanten (25, 125) durchgehend und über ihre Länge gleichförmig, insbesondere jeweils mit konstantem Profil, ausgebildet sind, wobei vorzugsweise die Ausbildung der beiden Endkanten (25, 125) zueinander spiegelbildlich ist, insbesondere die beiden die Ausdehnungsrichtung begrenzenden Endkanten (25, 125) gerade und/oder parallel zueinander sind.

5. Bedienvorrichtung nach einem der vorstehenden Ansprüche, **dadurch gekennzeichnet, dass** eine zwischen der Rückseite (24, 124) und der Vorderseite (23, 123) entlang der Endkante (25, 125) verlaufende Endkantenfläche (26, 126) durchgehend, insbesondere gerade, ausgebildet ist, dass die Endkantenfläche (26, 126) einen konstanten Endkantenwinkel zur Rückseite (24, 124) bildet, wobei der Endkantenwinkel vorzugsweise zwischen 15° und 60° beträgt.

6. Bedienvorrichtung nach einem der Ansprüche 1 bis 4, **dadurch gekennzeichnet, dass** eine sich zwischen der Rückseite (24, 124) und der Vorderseite (23, 123) entlang der Endkante (25, 125) erstreckende Endkantenfläche (26, 126) in Richtung von der Rückseite (24, 124) zur Vorderseite (23, 123) nicht durchgehend ausgebildet ist, insbesondere stufenförmig mit mindestens einer Stufe ausgebildet ist, wobei vorzugsweise eine an die Rückseite (24, 124) angrenzende Stufe weniger hoch als eine halbe Dicke des Sensorbauteilträgers (22, 122) ist.

7. Bedienvorrichtung nach einem der vorhergehenden Ansprüche, **dadurch gekennzeichnet, dass** die Vorderseite (23, 123) des Sensorbauteilträgers (22, 122) über den Haltevorsprüngen (28, 128) oder über den höchsten Endkanten (26, 126) des Sensorbauteilträgers (22, 122) mindestens 10 % ihrer Dicke aufweist, wobei vorzugsweise die Haltevorrichtung (30, 130) die Endkanten (25, 125) oder die Endkantenflächen (26, 126) nicht vollständig bis zur Vorderseite (23, 123) überlappt, wobei vorzugsweise die Haltevorsprünge (28, 128) die höchsten Teile oder Bereiche der Haltevorrichtung (30, 130) bilden und/oder kein anderer Bereich der Haltevorrichtung (30, 130) höher ist als die Haltevorsprünge (28, 128).

8. Bedienvorrichtung nach einem der vorhergehenden Ansprüche, **dadurch gekennzeichnet, dass** die Haltevorsprünge (28, 128) in einem Bereich, der zu den Endkanten (25, 125) oder Endkantenflächen (26, 126) des Sensorbauteilträgers (22, 122) weist und gegebenenfalls auf diesen aufliegt, exakt komplementär zu den Endkanten (25, 125) oder Endkantenflächen (26, 126) des Sensorbauteilträgers (22, 122) ausgebildet sind.

9. Bedienvorrichtung nach einem der vorhergehenden Ansprüche, **dadurch gekennzeichnet, dass** der Sensorbauteilträger (22, 122) ohne Schrauben oder dergleichen fest in der Haltevorrichtung (30, 130) sitzt und insbesondere mittels einer Rastverbindung oder mittels einer Klemmung gegen Bewegung gesichert ist.

10. Bedienvorrichtung nach einem der vorstehenden Ansprüche, **dadurch gekennzeichnet, dass** die Vorderseite (23, 123) des Sensorbauteilträgers (22, 122) mit den kapazitiven Sensorelementen (20, 120) in Richtung senkrecht zu seiner Oberfläche den höchsten Bereich der Bedienvorrichtung (11) bildet, wobei insbesondere der Sensorbauteilträger (22, 122) mit mindestens 10 % seiner Dicke über die anderen Teile oder Bereiche der Bedienvorrichtung (11) wie die Haltevorrichtung (30, 130) hinausragt.

11. Bedienvorrichtung nach einem der vorstehenden Ansprüche, **dadurch gekennzeichnet, dass** die kapazitiven Sensorelemente (20, 120) durch eine metallische Beschichtung des Sensorbauteilträgers (22, 122), insbesondere durch eine Beschichtung mit Kupfer, gebildet sind.

12. Bedienvorrichtung nach einem der vorstehenden Ansprüche, **dadurch gekennzeichnet, dass** der Sensorbauteilträger (22, 122) eine herkömmliche Leiterplatte mit Beschichtungen in Form von Leiterbahnen oder leitenden Flächen auf der Vorderseite (23, 123) und/oder auf der Rückseite (24, 124) ist.

13. Bedienvorrichtung nach einem der vorstehenden Ansprüche, **dadurch gekennzeichnet, dass** die kapazitiven Sensorelemente (20, 120) auf der Vorderseite (23, 123) des Sensorbauteilträgers (22, 122) mittels Durchkontaktierungen (40) an Leiterbahnen und/oder an Kontaktfelder (41) auf der Rückseite (24, 124) des Sensorbauteilträgers (22, 122) leitend verbunden sind, wobei vorzugsweise eine elektrische Kontaktierung zwischen Leiterbahnen und/oder Kontaktfeldern auf der Rückseite (24, 124) des Sensorbauteilträgers (22, 122) und dem Grundbauteilträger (34) mittels elastischer oder formveränderlicher, elektrisch leitender Körper (43) oder Federn oder verformbarer, elektrisch leitender Körper oder Federn vorgesehen ist, wobei insbesondere auf dem Sensorbauteilträger (22, 122) nur die kapazitiven Sensorelemente (20, 120) und Durchkontaktierungen (40) und Leiterbahnen und Kontaktfelder (41), aber keine separaten oder diskreten elektrischen Bauelemente vorgesehen sind, wobei vorzugsweise auf der Vorderseite (23, 123) nur die kapazitiven Sensorelemente (20, 120) vorgesehen sind.

14. Bedienvorrichtung nach einem der vorstehenden Ansprüche, **dadurch gekennzeichnet, dass** neben dem Sensorbauteilträger (22, 122), der vorzugsweise in einer parallelen Ebene verläuft, eine Anzeigevorrichtung, insbesondere ein LC-Display (16) oder eine LED-Anzeige, angeordnet ist, wobei vorzugsweise die Anzeigevorrichtung (16) nicht über die Ebene der Vorderseite (23, 123) des Sensorbauteilträgers (22, 122) hinausragt.

15. Elektrisches Haushaltsgerät (BO) mit einer Bedienvorrichtung (11) nach einem der vorhergehenden Ansprüche, **dadurch gekennzeichnet, dass** das Haushaltsgerät (BO) ein Bedienfeld (OP) aufweist, hinter dem die Bedienvorrichtung (11) angeordnet ist, wobei die Bedienvorrichtung (11) zumindest mit der Vorderseite (23, 123) des Sensorbauteilträgers (22, 122) oder mit den kapazitiven Sensorelementen (20, 120) gegen die Rückseite des Bedienfelds (OP) gedrückt wird, wobei insbesondere der Sensorbauteilträger (22, 122) parallel zur Bedienoberfläche (OP) bzw. zur Rückseite des Bedienfelds (OP) verläuft.

## Revendications

1. Dispositif de commande (11) pour un appareil électroménager (BO), le dispositif de commande (11) comportant :
- un support de composants de capteur (22, 122) plat et plan avec une face avant (23, 123) et une face arrière (24, 124), au moins un élément de capteur capacitif (20, 120) étant disposé sur la face avant (23, 123),
- un autre support de composants de base (34) avec des composants de circuit électrique (35) sur celui-ci,
- un dispositif de maintien (30, 130) pour le support de composants de capteur (22, 122) étant monté sur le support de composants de base (34),
dans lequel
- le support de composants de capteur (22, 122) présente un prolongement plan avec une direction de prolongement et des bords d'extrémité (25, 125), la direction de prolongement s'étendant d'un bord d'extrémité (25, 125) à l'autre bord d'extrémité (25, 125) de telle sorte que les bords d'extrémité (25, 125) s'étendent transversalement à la direction de prolongement,
- le support de composant de capteur (22, 122) est plus étroit le long de la direction d'extension au niveau de la face avant (23, 123) qu'au niveau de la face arrière (24, 124) de telle sorte que la face arrière (24, 124) dépasse de la face avant (23, 123) au niveau des deux bords d'extrémité (25, 125) dans la projection sur le support de composant de capteur (22, 122),
- le dispositif de maintien (30, 130) s'étend essentiellement sur ou sous la face arrière (24, 124) du support de composant de capteur (22, 122) et comporte des saillies de maintien (28, 128),
- le dispositif de maintien (30, 130) recouvre partiellement les bords d'extrémité (25, 125) ou les faces de bord d'extrémité (26, 126) du support de composant de capteur (22, 122) sur des côtés opposés du support de composant de capteur (22, 122) avec dans chaque cas au moins l'une des saillies de maintien (28, 128) et maintient le support de composant de capteur (22, 122) dans le sens perpendiculaire à sa surface,
**caractérisé en ce que**
- le dispositif de maintien (30, 130) ne recouvre pas complètement les bords d'extrémité (25, 125) ou les faces de bord d'extrémité (26, 126) jusqu'à la face avant (23, 123),
- la face avant (23, 123) du support de composants de capteur (22, 122) est plus haute dans une direction allant du support de composants de base (34) au support de composants de capteur (22, 122) que n'importe quelle partie du dispositif de maintien (30, 130), y compris les saillies de maintien (28, 128).

2. Dispositif de commande selon la revendication 1, **caractérisé en ce que** le support de composant de capteur (22, 122) est allongé avec une longueur qui est au moins 50 % plus grande que la largeur, la direction d'extension étant perpendiculaire à la direction longitudinale du support de composant de capteur (22, 122) et définissant la largeur du support de composant de capteur (22, 122), la largeur au niveau de la face arrière (24, 124) étant supérieure à la largeur au niveau de la face avant (23, 123).

3. Dispositif de commande selon la revendication 1 ou 2, **caractérisé en ce que** la face arrière (24, 124) dans le sens de l'extension est plus large que la face avant (23, 123) d'un total de 1 mm à 4 mm ou de 50 % à 500 % de l'épaisseur du support de composant de capteur (22, 122).

4. Dispositif de commande selon l'une des revendications précédentes, **caractérisé en ce que** les deux bords d'extrémité (25, 125) sont conçus de manière continue et uniforme sur toute leur longueur, en particulier avec un profil constant dans chaque cas, la conception des deux bords d'extrémité (25, 125) étant de préférence symétrique l'une de l'autre, en particulier les deux bords d'extrémité (25, 125) qui délimitent la direction d'extension étant droits et/ou parallèles l'un à l'autre.

5. Dispositif de commande selon l'une des revendications précédentes, **caractérisé en ce qu'**une face de bord d'extrémité (26, 126) qui s'étend entre la face arrière (24, 124) et la face avant (23, 123) le long du bord d'extrémité (25, 125) est formée de manière continue, en particulier s'étend de manière rectiligne, de telle manière que la face de bord d'extrémité (26, 126) forme un angle de bord d'extrémité constant par rapport à la face arrière (24, 124), l'angle de bord d'extrémité étant de préférence compris entre 15° et 60°.

6. Dispositif de commande selon l'une quelconque des revendications 1 à 4, **caractérisé en ce qu'**une face de bord d'extrémité (26, 126) s'étendant entre la face arrière (24, 124) et la face avant (23, 123) le long du bord d'extrémité (25, 125) est formée de manière non continue dans la direction allant de la face arrière (24, 124) à la face avant (23, 123), en particulier en forme de gradin avec au moins un gradin, dans lequel de préférence un gradin adjacent à la face arrière (24, 124) est moins haut que la moitié d'une épaisseur du support de composant de capteur (22, 122).

7. Dispositif de commande selon l'une des revendications précédentes, **caractérisé en ce que** la face avant (23, 123) du support de composant de capteur (22, 122) a au moins 10 % de son épaisseur au-dessus des saillies de maintien (28, 128) ou au-dessus des faces de bord d'extrémité les plus élevées (26, 126) du support de composant de capteur (22, 122), dans lequel, de préférence, le dispositif de maintien (30, 130) ne chevauche pas complètement les bords d'extrémité (25, 125) ou les faces de bord d'extrémité (26, 126) jusqu'à la face avant (23, 123), dans lequel de préférence les saillies de maintien (28, 128) forment les parties ou zones les plus hautes du dispositif de maintien (30, 130) et/ou aucune autre zone du dispositif de maintien (30, 130) n'est plus haute que les saillies de maintien (28, 128).

8. Dispositif de commande selon l'une des revendications précédentes, **caractérisé en ce que** les saillies de maintien (28, 128) sont formées exactement de manière complémentaire aux bords d'extrémité (25, 125) ou aux faces de bord d'extrémité (26, 126) du support de composant de capteur (22, 122) dans une région qui est dirigée vers les bords d'extrémité (25, 125) ou les faces de bord d'extrémité (26, 126) du support de composant de capteur (22, 122) et, le cas échéant, repose sur celui-ci.

9. Dispositif de commande selon l'une des revendications précédentes, **caractérisé en ce que** le support de composants de capteur (22, 122) est fermement logé dans le dispositif de maintien (30, 130) sans vis ou similaire, et en particulier est immobilisé au moyen d'un assemblage par encliquetage ou d'un dispositif de serrage.

10. Dispositif de commande selon l'une des revendications précédentes, **caractérisé en ce que** la face avant (23, 123) du support de composants de capteur (22, 122) avec les éléments de capteur capacitifs (20, 120) forme la zone la plus haute du dispositif de commande (11) dans une direction perpendiculaire à sa surface, dans lequel en particulier le support de composant de capteur (22, 122) dépasse d'au moins 10 % de son épaisseur au-dessus des autres parties ou régions du dispositif de commande (11) telles que le dispositif de maintien (30, 130).

11. Dispositif de commande selon l'une des revendications précédentes, **caractérisé en ce que** les éléments de capteur capacitif (20, 120) sont formés par un revêtement métallique du support de composants de détection (22, 122), en particulier par un revêtement en cuivre.

12. Dispositif de commande selon l'une des revendications précédentes, **caractérisé en ce que** le support de composants de capteur (22, 122) est une carte de circuit imprimé classique avec des revêtements sous forme de pistes conductrices ou de surfaces conductrices sur la face avant (23, 123) et/ou sur la face arrière (24, 124).

13. Dispositif de commande selon l'une des revendications précédentes, **caractérisé en ce que** les éléments de capteur capacitifs (20, 120) sur la face avant (23, 123) du support de composants de capteur (22, 122) sont reliés de manière conductrice au moyen de métallisations de traversée (40) à des pistes conductrices et/ou des champs de contact (41) sur la face arrière (24, 124) du support de composants de capteur (22, 122), dans lequel de préférence un contact électrique entre les pistes conductrices et/ou les champs de contact sur la face arrière (24, 124) du support de composants de capteur (22, 122) et le support de composants de base (34) est assuré au moyen de corps (43) ou de ressorts élastiques ou à changement de forme, conducteurs de l'électricité ou de corps ou de ressorts déformables, conducteurs de l'électricité, dans lequel en particulier seuls les éléments de capteur capacitifs (20, 120) et les métallisations de passage (40) et les pistes conductrices et les champs de contact (41) sont prévus sur le support de composant de capteur (22, 122), mais aucun composant électrique séparé ou discret, dans lequel de préférence seuls les éléments de capteur capacitifs (20, 120) sont prévus sur la face avant (23, 123).

14. Dispositif de commande selon l'une des revendications précédentes, **caractérisé en ce qu'**un dispositif d'affichage, en particulier un écran LCD (16) ou un écran LED, est disposé à côté du support de composants de capteur (22, 122), qui s'étend de préférence dans un plan parallèle, le dispositif d'affichage (16) ne dépassant de préférence pas le plan de la face avant (23, 123) du support de composants de capteur (22, 122).

15. Appareil électroménager (BO) avec un dispositif de commande (11) selon l'une des revendications précédentes, **caractérisé en ce que** l'appareil électroménager (BO) comporte un panneau de commande (OP) derrière lequel est disposé le dispositif de commande (11), dans lequel le dispositif de commande (11) est pressé au moins avec la face avant (23, 123) du support de composants de capteur (22, 122) ou avec les éléments de capteur capacitifs (20, 120) contre la face arrière du panneau de commande (OP), dans lequel en particulier le support de composant de capteur (22, 122) s'étend parallèlement au panneau de commande (OP) ou à la face arrière du panneau de commande (OP).
